(19) Europäisches Patentamt / European Patent Office / Office européen des brevets

(11) **EP 4 502 722 A1**

(12) **EUROPEAN PATENT APPLICATION**
published in accordance with Art. 153(4) EPC

(43) Date of publication:
05.02.2025 Bulletin 2025/06

(21) Application number: 23780893.6

(22) Date of filing: 30.03.2023

(51) International Patent Classification (IPC):
**G02F 1/35** (2006.01)

(52) Cooperative Patent Classification (CPC):
**G02F 1/35**

(86) International application number:
**PCT/JP2023/013208**

(87) International publication number:
**WO 2023/190885 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 30.03.2022 JP 2022056471

(71) Applicant: FURUKAWA ELECTRIC CO., LTD.
Tokyo 100-8322 (JP)

(72) Inventors:
• OGOSHI, Haruki
  Tokyo 100-8322 (JP)
• YOSHIDA, Junji
  Tokyo 100-8322 (JP)
• INABA, Yusuke
  Ichihara-shi, Chiba 290-8555 (JP)

• ICHINO, Seiji
  Tokyo 100-8322 (JP)
• TATAMIDA, Yasuto
  Tokyo 100-8322 (JP)
• TAKASAKA, Shigehiro
  Tokyo 100-8322 (JP)
• SUGIZAKI, Ryuichi
  Tokyo 100-8322 (JP)
• THUDSALINGKARNSAKUL, Nitidet
  Ayutthaya 13210 (TH)
• ANANTATHANASARN, Sanguan
  Ayutthaya 13210 (TH)
• PHOKEAW, Supadda
  Ayutthaya 13210 (TH)

(74) Representative: SSM Sandmair
Patentanwälte Rechtsanwalt
Partnerschaft mbB
Joseph-Wild-Straße 20
81829 München (DE)

(54) **RAMAN AMPLIFIER AND METHOD OF DESIGNING RAMAN AMPLIFIER**

(57) A Raman amplifier includes: a Raman amplification optical fiber configured to Raman amplify incoherent light in which relative intensity noise (RIN) is suppressed while transmitting the incoherent light; and a pumping light source configured to supply pumping light to the Raman amplification optical fiber, in which a corner frequency fc [Hz] at which the suppression of the RIN starts in the Raman-amplified incoherent light is estimated by using the following Equation (1): $fc=1/(D \cdot \Delta\lambda \cdot L)$ (1), in which a full width at half maximum of a wavelength spectrum of the incoherent light is $\Delta\lambda$ [nm], a length of the Raman amplification optical fiber is L [km], and an absolute value of chromatic dispersion of the Raman amplification optical fiber at a center wavelength of the incoherent light is D [ps/nm/km].

FIG.16

EP 4 502 722 A1

**Description**

Field

The present invention relates to a Raman amplifier and a method for designing the Raman amplifier.

Background

In optical fiber communication, transmission distances and transmission capacities have been increased using an erbium-doped fiber amplifier (EDFA). However, nowadays, it is essential to utilize not only the EDFA but also Raman amplification and effectively combine the EDFA and the Raman amplification. Currently, backward pumped Raman amplification in which pumping light is incident on an optical fiber for Raman amplification so as to propagate in a direction opposite to a direction of propagation of signal light is mainly used as the Raman amplification. However, in order to further increase a speed (800Gb/s), increase a distance (1000 km transmission), and increase a bandwidth (utilization of L- and S-band) for the next generation, it is important to use a method called forward pumped Raman amplification in which the pumping light is incident on the optical fiber for Raman amplification so as to propagate in the same direction as the direction of propagation of signal light simultaneously with the backward pumped Raman amplification. This method is called bidirectionally pumped Raman amplification. Note that it has been reported that, by using a wavelength multiplexing pumping method, flattening of a Raman gain and the increase in bandwidth can be achieved only by the backward pumped Raman amplification, but flattening of a noise figure (NF) cannot be achieved unless the bidirectionally pumped Raman amplification is used (Non Patent Literatures 1 and 2).

In forward pumping, a pumping light source having a small relative intensity noise (RIN) is required. The reason is as follows.

The RIN is an index obtained by normalizing a minute intensity variation component of laser light with total optical power. In the phenomenon of Raman amplification, since a lifetime of an excited level that generates a gain is short ($\approx$ several fsec), when there is intensity noise in the pumping light source, the noise directly becomes noise of the signal light through an amplification process. In the EDFA, since the lifetime of the excited level is long ($\approx$ 10 msec), there is no such possibility. In the Raman amplification, a gain per unit length is very small compared to the EDFA, but in the forward pumped Raman amplification, the signal light and the pumping light propagate together in the optical fiber over a long distance, so that noise of the pumping light is gradually transferred as the noise of the signal light. This is called RIN transfer. In the backward pumped Raman amplification, since the signal light and the pumping light are opposite to each other, a time during which the pumping light having a certain noise component and the signal light intersect each other is short, and an influence of the noise of the pumping light on the signal light is small. In addition, since the noise of the pumping light is random, the influence on the signal light is averaged as the signal light travels in the opposite direction. As can be seen from the above, in the forward pumped Raman amplification, a low-RIN transfer characteristic is required, and particularly in a dispersion shifted fiber (DSF), a non-zero dispersion shifted fiber (NZDSF), or the like in which a group velocity difference between the signal light and the pumping light is small and a time for transmission in the optical fiber in parallel is long, reduction of the RIN transfer is important (Non Patent Literatures 3, 4, and 5). The NZDSF is, for example, an optical fiber conforming to ITU-T G.655 standard of the International Telecommunication Union (ITU).

According to Non Patent Literature 6, in a case where a C-band and an L-band are collectively amplified, it is necessary to multiplex about six Fabry-Perot (FP)-laser diode (LD)-type pumped lasers having different wavelengths in order to obtain a flat wavelength gain characteristic (hereinafter, referred to as gain flatness) of 0.5 dB or less. This is called a wavelength multiplexing pumping technology, and has been widely put into practical use. Hereinafter, the C-band and the L-band may be collectively referred to as a C+L-band.

On the other hand, amplified spontaneous emission (ASE) light from a semiconductor optical amplifier (SOA) is broadband, with a full width at half maximum (FWHM) of a power spectrum of 25 nm or more. As a result, compared with the FP-LD type pumped laser, it is advantageous to implement the gain flatness in the case of collectively amplifying the C+L-band. A result of simulating such a state will be described.

Conditions of the simulation are as shown in Table 1 below. A standard single-mode optical fiber (SMF) is an optical fiber conforming to the ITU-T G.652 standard. Conditions 1 and 3 correspond to a case where the ASE light of the SOA is used as the pumping light of the Raman amplification. Condition 2 corresponds to a case where laser light from the FP-LD laser is used as the pumping light of the Raman amplification.

Table 1

| Pumping light wavelength (nm) | 1425 | 1455 | 1495 |
|---|---|---|---|
| Pumping light power (mW) (Conditions 1 and 2) | 350 | 180 | 130 |
| Pumping light power (mW) (Condition 3) | 200 | 180 | 130 |

(continued)

> Input signal light power: -7 dBm
> Raman amplification optical fiber: standard single-mode optical fiber (SMF) with length of 40 km
> FWHM of ASE light of SOA: 25 nm
> FWHM of laser light from FP-LD type laser: 1 nm
> Target Raman gain: 8 dB
> C-band: 1530 to 1560 nm
> L-band: 1570 to 1600 nm

Here, since a propagation loss of the standard single-mode optical fiber is about 0.2 dB/km, a loss of the standard single-mode optical fiber having a length of 40 km is 8 dB. A target gain for compensating the loss with the Raman amplification is 8 dB. Here, in a normal transmission system design, in consideration of a balance between improvement of an optical signal noise ratio (OSNR) by the forward pumped Raman amplification and suppression of a nonlinear phenomenon due to an increase in light power in a transmission fiber by the Raman amplification, the forward pumped Raman amplification shares compensation for a fiber loss of 1/3 to 1/2 of the entire length of the transmission system. For example, when 1/3 is shared, the total length of the transmission system is 120 km. This is a distance equivalent to that of a widely adopted transmission system.

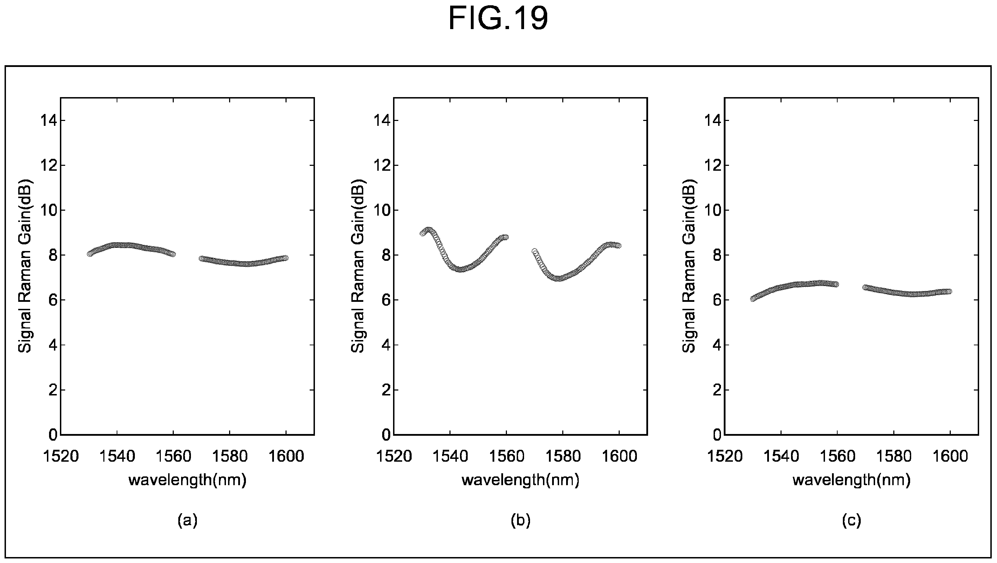

FIGS. 19(a), 19(b), and 19(c) are diagrams illustrating Raman gain spectra obtained under Condition 1, Condition 2, and Condition 3, respectively. As illustrated in FIG. 19(a), in the case of Condition 1 using the ASE light of the SOA, the gain flatness over the entire C+L-band can be implemented only by excitation of three different wavelengths. On the other hand, as illustrated in FIG. 19(b), in the case of Condition 2 using the laser light from the FP-LD type laser, the gain flatness over the entire C+L-band is significantly deteriorated as compared with the case of FIG. 19(a). This result is the same as the result shown in Non Patent Literature 6. In addition, Patent Literature 2 and Non Patent Literature 12 also disclose in detail that Raman amplification using broadband ASE light as the pumping light is extremely advantageous for gain flattening.

However, in order to implement the Raman gain of 8 dB and the gain flatness, as can be seen from Table 1, pumping light power on a short wavelength side (1425 nm in Table 1) is extremely higher than pumping light power on a long wavelength side. This is a phenomenon that occurs when signal light power on the short wavelength side is used for amplification of signal optical power on the long wavelength side, and is called inter-channel stimulated Raman scattering (ISRS), which is particularly noticeable in broadband transmission such as the C+L-band (Non Patent Literature 7). Specifically, in the case of Condition 1, the pumping light power on the short wavelength side (1425 nm) necessary for obtaining the Raman gain of 8 dB reaches 350 mW.

On the other hand, for example, a value of 200 mW or more has already been achieved as the ASE light from the SOAs connected in multiple stages, but it is not easy to achieve a value of more than 300 mW. Therefore, when the pumping light power of 1425 nm is set to a realistic value of 200 mW as in Condition 3 in Table 1, the gain does not reach the target value of 8 dB as illustrated in FIG. 19(c).

Furthermore, in an actual system, it is considered that the required pumping light power further increases by 30% or more due to a loss of various optical components for connecting the pumping light source and the transmission fiber.

Since the FP-LD type pumped laser that is currently widely used has a small FWHM of about 1 nm, the total pumping power can be easily increased by the technology of wavelength multiplexing pumping. However, since the ASE light from the SOA is broadband, the ASE light is not suitable for the wavelength multiplexing pumping which is widely used. The FWHM of the ASE light from the SOA reaches about 25 nm or more, and is substantially equal to, for example, 30 nm which is the bandwidth of the C-band.

Here, one of means for increasing pumping power of the same wavelength is a polarization multiplexing technology. The polarization multiplexing technology can be easily applied by using a polarization maintaining fiber as an output fiber of the SOA. However, there is actually a loss in a polarization multiplexing optical component itself, and there is also a limit to the pumping power that can be achieved by the method. Therefore, in order to perform C+L-band collective amplification utilizing a broadband property of the ASE light, it is necessary to amplify the ASE light on the short wavelength side by some means or method.

Citation List

Patent Literature

Patent Literature 1: JP 2016-212370 A
Patent Literature 2: US 7,215,836

Non Patent Literature

Non Patent Literature 1: KADO, Soko, et al. Broadband flat-noise Raman amplifier using low-noise bidirectionally pumping sources. In: Proceedings 27th European Conference on Optical Communication (Cat. No. 01TH8551). IEEE, 2001. p. 38-39.
Non Patent Literature 2: EMORI, Yoshihiro; KADO, Soko; NAMIKI, Shu. Independent control of the gain and noise figure spectra of Raman amplifiers using bidirectional pumping. Furukawa Review, 2003, 23: 11-15.
Non Patent Literature 3: PELOUCH, Wayne S. Raman amplification: An enabling technology for long-haul coherent transmission systems. Journal of Lightwave Technology, 2015, 34.1: 6-19.
Non Patent Literature 4: KEITA, Kafing, et al. Relative intensity noise transfer of large-bandwidth pump lasers in Raman fiber amplifiers. JOSA B, 2006, 23.12: 2479-2485.
Non Patent Literature 5: FLUDGER, C. R. S.; HANDEREK, V.; MEARS, R. J. Pump to signal RIN transfer in Raman fiber amplifiers. Journal of Lightwave Technology, 2001, 19.8: 1140.
Non Patent Literature 6: NAMIKI, Shu; EMORI, Yoshihiro. Broadband Raman amplifiers design and practice. In: Optical Amplifiers and Their Applications. Optical Society of America, 2000.p.OMB2.
Non Patent Literature 7: SAAVEDRA, Gabriel, et al. Inter-channel stimulated Raman scattering and its impact in wideband transmission systems. In: 2018 Optical Fiber Communications Conference and Exposition (OFC). 2018.p.Th1C.3.
Non Patent Literature 8: YAMATOYA, T.; KOYAMA, F.; IGA, K. Noise suppression and intensity modulation using gain-saturated semiconductor optical amplifier. In: Optical Amplifiers and Their Applications. Optical Society of America, 2000. p. OMD12.
Non Patent Literature 9: KOYAMA, F. High power superluminescent diodes for multi-wavelength light sources. In: Conference Proceedings. LEOS'97. 10th Annual Meeting IEEE Lasers and Electro-Optics Society 1997 Annual Meeting. IEEE, 1997. p. 333-334.
Non Patent Literature 10: ZHAO, Mingshan; MORTHIER, Geert; BAETS, Roel. Analysis and optimization of intensity noise reduction in spectrum-sliced WDM systems using a saturated semiconductor optical amplifier. IEEE Photonics Technology Letters, 2002, 14.3: 390-392.
Non Patent Literature 11: MORIMOTO, Masahito, et al. Co-propagating dual-order distributed Raman amplifier utilizing incoherent pumping. IEEE Photonics Technology Letters, 2017, 29.7: 567-570.
Non Patent Literature 12: VAKHSHOORI, D., et al. Raman amplification using high-power incoherent semiconductor pump sources. In: Optical Fiber Communication Conference. Optical Society of America, 2003. p. PD47.

Summary

Technical Problem

As a method of amplifying the ASE light of the SOA, a Raman amplification technology, particularly, a lumped Raman amplification technology can be considered. As disclosed in Patent Literature 1, the ASE light that is incoherent light is incoherent light even when the Raman amplification is performed. Therefore, the Raman amplification is effective as a method of amplifying the ASE light of the SOA.

On the other hand, in the ASE light of the SOAs connected in multiple stages, RIN on a low frequency side is suppressed (Non Patent Literatures 8, 9, and 10). This is an extremely beneficial characteristic from the viewpoint of suppressing the RIN transfer, which is a problem of the forward pumped Raman amplification.

Therefore, it is preferable that the ASE light in which the RIN is suppressed can be Raman amplified while maintaining an RIN suppression characteristic.

Here, it is known that a band in which the RIN is suppressed in the ASE light in which the RIN is suppressed (which may hereinafter be referred to as an RIN suppression band) is narrowed after propagating through the optical fiber (Non Patent Literature 12). In Non Patent Literature 12, it is pointed out that the narrowing of the RIN suppression band is caused by chromatic dispersion of the optical fiber.

However, Non Patent Literature 12 does not show a quantitative relationship between the RIN suppression band and the chromatic dispersion of the optical fiber. Furthermore, how the RIN suppression band and the RIN itself change when the ASE light is Raman amplified has not yet been clarified.

The present invention has been made in view of the above, and an object of the present invention is to provide a Raman amplifier having a controlled RIN suppression band and a method for designing the Raman amplifier.

Solution to Problem

To solve the problem described above and to achieve the object, a Raman amplifier according to one aspect of the present invention includes: a Raman amplification optical fiber configured to Raman amplify incoherent light in which relative intensity noise (RIN) is suppressed while transmitting the incoherent light; and a pumping light source configured to supply pumping light to the Raman amplification optical fiber. A corner frequency fc [Hz] at which the suppression of the RIN starts in the Raman-amplified incoherent light is estimated by using the following Equation (1):

$$\mathrm{fc}=1/(\mathrm{D}\cdot\Delta\lambda\cdot\mathrm{L}) \qquad\qquad (1)$$

in which a full width at half maximum of a wavelength spectrum of the incoherent light is $\Delta\lambda$ [nm], a length of the Raman amplification optical fiber is L [km], and an absolute value of chromatic dispersion of the Raman amplification optical fiber at a center wavelength of the incoherent light is D [ps/nm/km].

In the Raman amplifier, the Raman amplifier can be configured to have a combination of $\Delta\lambda$, L, and D to be fc of 10 GHz or more.

In the Raman amplifier, the Raman amplifier can be configured to have a combination of $\Delta\lambda$, L, and D to be fc of 1 GHz or more.

In the Raman amplifier, the Raman amplifier can be configured to have a combination of $\Delta\lambda$, L, and D to be fc of 500 MHz or more.

In the Raman amplifier, the Raman amplifier can be configured to have a combination of $\Delta\lambda$, L, and D to be fc of 100 MHz or more.

In the Raman amplifier, the incoherent light can be output from an incoherent light source including semiconductor optical amplifiers connected in multiple stages.

In the Raman amplifier, the incoherent light source can be driven such that the relative intensity noise (RIN) and ripple are simultaneously suppressed in the incoherent light.

A method for designing a Raman amplifier according to one aspect of the present invention is a method for designing a Raman amplifier including a Raman amplification optical fiber configured to Raman amplify incoherent light in which relative intensity noise (RIN) is suppressed while transmitting the incoherent light, and a pumping light source configured to supply pumping light to the Raman amplification optical fiber. The method includes: estimating a corner frequency fc [Hz] at which the suppression of the RIN starts in the Raman-amplified incoherent light by using the following Equation (1):

$$\mathrm{fc}=1/(\mathrm{D}\cdot\Delta\lambda\cdot\mathrm{L}) \qquad\qquad (1)$$

in which a full width at half maximum of a wavelength spectrum of the incoherent light is $\Delta\lambda$ [nm], a length of the Raman amplification optical fiber is L [km], and an absolute value of chromatic dispersion of the Raman amplification optical fiber at a center wavelength of the incoherent light is D [ps/nm/km].

Advantageous Effects of Invention

According to the present invention, a Raman amplifier having a controlled RIN suppression band and a method for designing the Raman amplifier are provided.

Brief Description of Drawings

FIG. 1 is a schematic diagram of a light source device including an incoherent light source.
FIG. 2 is a diagram illustrating a part of a light source module illustrated in FIG. 1.
FIG. 3 is a diagram illustrating an example of a power spectrum of output light of a booster amplifier.
FIG. 4 is a diagram illustrating an example of power (Pf) of output light with respect to Ib.
FIG. 5 is a diagram illustrating an example of a relative intensity noise (RIN) spectrum of the output light.
FIG. 6 is a diagram schematically illustrating a spectrum in which RIN is suppressed.
FIG. 7 is a diagram illustrating an example of a power spectrum of the output light when Is is set to 0 mA and Ib is changed.

FIG. 8 is a diagram illustrating an example of a power spectrum of the output light when Is is changed.

FIG. 9 is a schematic diagram of a Raman amplifier according to a first embodiment.

FIG. 10 is a schematic diagram of a Raman amplifier according to a second embodiment.

FIG. 11 is a diagram schematically illustrating RIN spectra of incoherent light, non-amplified light, and Raman-amplified light in the Raman amplifiers as in the first and second embodiments.

FIG. 12 is a diagram for describing that an RIN suppression band is narrowed.

FIG. 13 is a diagram illustrating RIN spectra of measurement examples 500, 501, and 600.

FIG. 14 is a diagram illustrating RIN spectra of measurement examples 510, 510-2, 610, and 610-2.

FIG. 15 is a diagram illustrating RIN spectra of measurement examples 510 and 530.

FIG. 16 is a diagram illustrating RIN spectra of measurement examples 521-2 and 521Rb-2.

FIG. 17 is a diagram illustrating RIN spectra of measurement examples 520Rf, 520Rb, and 610.

FIG. 18 is a schematic diagram of a Raman amplification system including the Raman amplifier according to the first embodiment.

FIG. 19 is a diagram illustrating a Raman gain spectrum.

Description of Embodiments

Hereinafter, embodiments of the present invention will be described with reference to the drawings. Note that the present invention is not limited by the embodiments described below. Furthermore, in the description of the drawings, the same portions are appropriately denoted by the same reference signs, and an overlapping description is omitted as appropriate.

The present inventors have found that, when incoherent light in which the RIN is suppressed propagates through an optical fiber, a corner frequency fc [Hz] at which suppression of relative intensity noise (RIN) starts is shifted to a low frequency side according to the following Equation (1):

$$\mathrm{fc} \ = \ 1/(\mathrm{D}\cdot\Delta\lambda\cdot\mathrm{L}) \qquad\qquad (1)$$

and the RIN suppression band is narrowed. Here, $\Delta\lambda$ [nm] is a full width at half maximum of a wavelength spectrum of the incoherent light, L [km] is a length of the optical fiber, and D [ps/nm/km] is an absolute value of chromatic dispersion of the optical fiber at the center wavelength of the incoherent light. Furthermore, it has been found that the corner frequency fc is also schematically represented by Equation (1) when the incoherent light in which the RIN is suppressed is Raman amplified by the optical fiber.

Therefore, it has been found that a Raman amplifier having a suitable RIN suppression band in a desired band can be implemented by designing or manufacturing a Raman amplifier by estimating the corner frequency fc using Equation (1).

Hereinafter, first, a configuration of an incoherent light source and suppression of the RIN and a ripple in the incoherent light source will be described, and then a configuration of a Raman amplifier and characteristics thereof will be described.

<Example of Configuration of Incoherent Light Source>

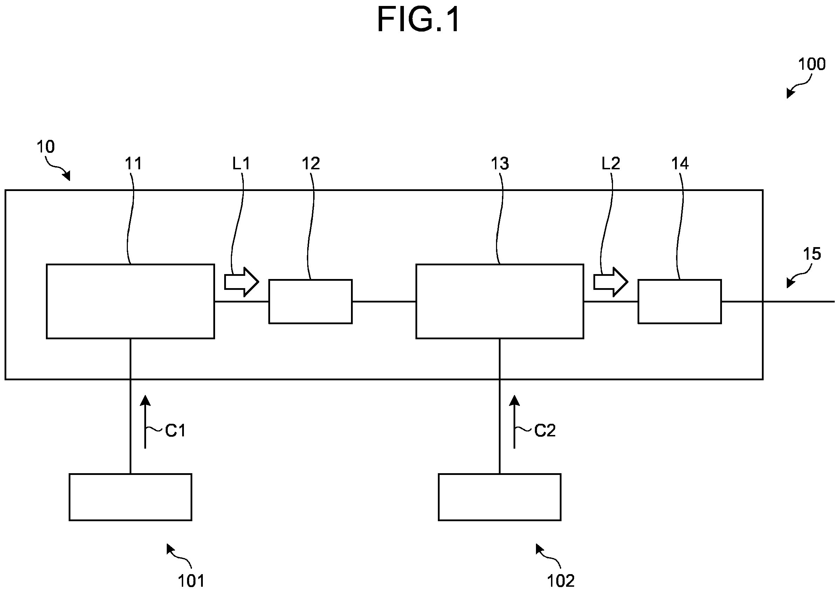

FIG. 1 is a schematic diagram of a light source device including the incoherent light source. A light source device 100 includes a light source module 10 and driving devices 101 and 102. The light source module 10 is an example of the incoherent light source.

The light source module 10 includes a seed light source 11 which is a semiconductor optical amplifier (SOA), an optical isolator 12, a booster amplifier 13 which is an SOA, an optical isolator 14, and an output optical fiber 15. The seed light source 11, the optical isolator 12, the booster amplifier 13, and the optical isolator 14 are optically connected in series in this order by an optical fiber, an optical element, or the like. That is, the light source module 10 includes the SOAs connected in multiple stages.

The seed light source 11 outputs incoherent seed light L1 having a predetermined bandwidth. Here, the seed light L1 is amplified spontaneous emission (ASE) light of the SOA. The incoherent light means not a laser light source oscillating in a single or a plurality of discrete modes (longitudinal modes) but light including a set of uncorrelated photons having a continuous spectrum. The predetermined bandwidth is, for example, a large bandwidth such as 25 nm or more as a wavelength bandwidth. The optical isolator 12 transmits the seed light L1 and causes the seed light L1 to be input to the booster amplifier 13, and prevents return light traveling from the booster amplifier 13 from being input to the seed light source 11. The optical isolator 12 prevents or reduces an unstable operation of the seed light source 11 caused by the input of the return light.

The booster amplifier 13 optically amplifies the input seed light L1 and outputs the amplified seed light L1 as incoherent light L2. The optical isolator 14 transmits the incoherent light L2 and causes the incoherent light L2 to be input to the output optical fiber 15, and prevents light traveling from the output optical fiber 15 from being input to the booster amplifier 13. The optical isolator 14 prevents or reduces an unstable operation of the booster amplifier 13 caused by the input of the return light.

The output optical fiber 15 is an optical fiber that guides the incoherent light L2 to the outside of the light source module 10.

The driving devices 101 and 102 are known driving devices for the SOA. The driving device 101 supplies a driving current C1 to the seed light source 11. The driving device 102 supplies a driving current C2 to the booster amplifier 13.

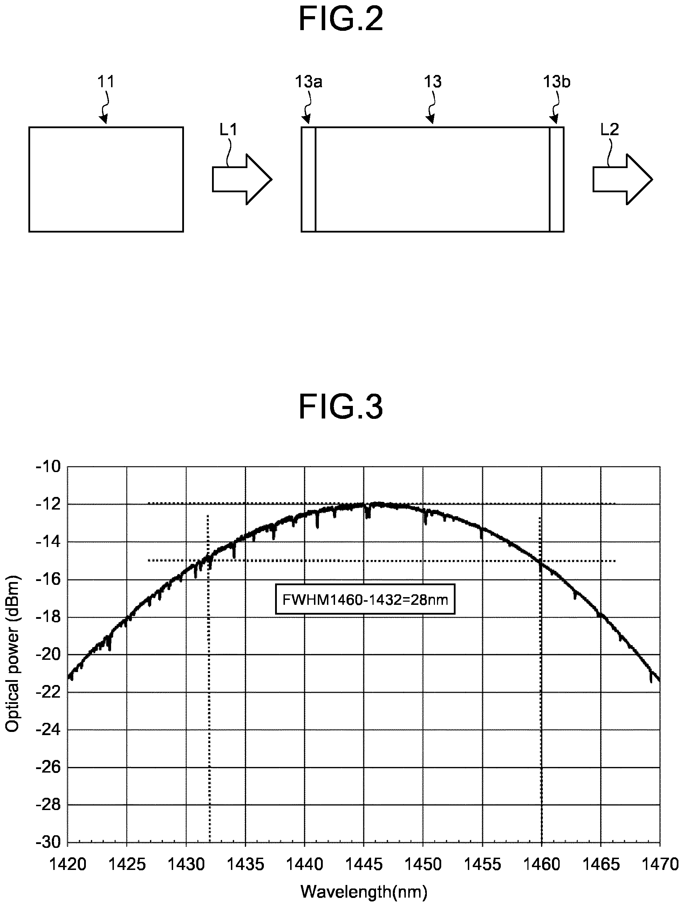

FIG. 2 is a diagram illustrating a part of the light source module 10 illustrated in FIG. 1. The booster amplifier 13 has a first facet 13a and a second facet 13b facing each other. The booster amplifier 13 receives the seed light L1 through the first facet 13a and outputs the incoherent light L2 to the outside through the second facet 13b.

The first facet 13a and the second facet 13b are subjected to reflection reduction processing such as ant-reflection (AR) coating. In addition, the first facet 13a and the second facet 13b may be inclined with respect to an optical axis of a light amplifying waveguide included in the booster amplifier 13 to be subjected to the reflection reduction processing. Such a structure is also referred to as an oblique waveguide structure.

Assuming that facet reflectivity of the first facet 13a is R1 and facet reflectivity of the second facet 13b is R2, R1 and R2 are, for example, in a range between $10^{-3}$ and $10^{-5}$. Alternatively, for example, $(R1 \times R2)^{1/2}$ is in a range between $10^{-3}$ and $10^{-5}$. A value of the range between $10^{-3}$ and $10^{-5}$ is an example of a sufficiently practical and feasible numerical range in terms of low reflectivity. Here, the range between $10^{-3}$ and $10^{-5}$ is a range including the upper limit of $10^{-3}$ and the lower limit of $10^{-5}$.

<Characteristics of Light Source Module 10>

Characteristics of the light source module 10 will be described. FIG. 3 is a diagram illustrating an example of a power spectrum of output light (incoherent light) of the booster amplifier. FIG. 3 illustrates a case where Is is set to 50 mA and Ib is set to 800 mA, where Is is the driving current C1 supplied to the seed light source 11 and Ib is the driving current C2 supplied to the booster amplifier 13. The power spectrum of the output light in FIG. 3 has a generally Gaussian spectrum shape, the center wavelength (measured using an RMS method) thereof is 1445 nm, and a full width at half maximum (FWHM) is about 28 nm.

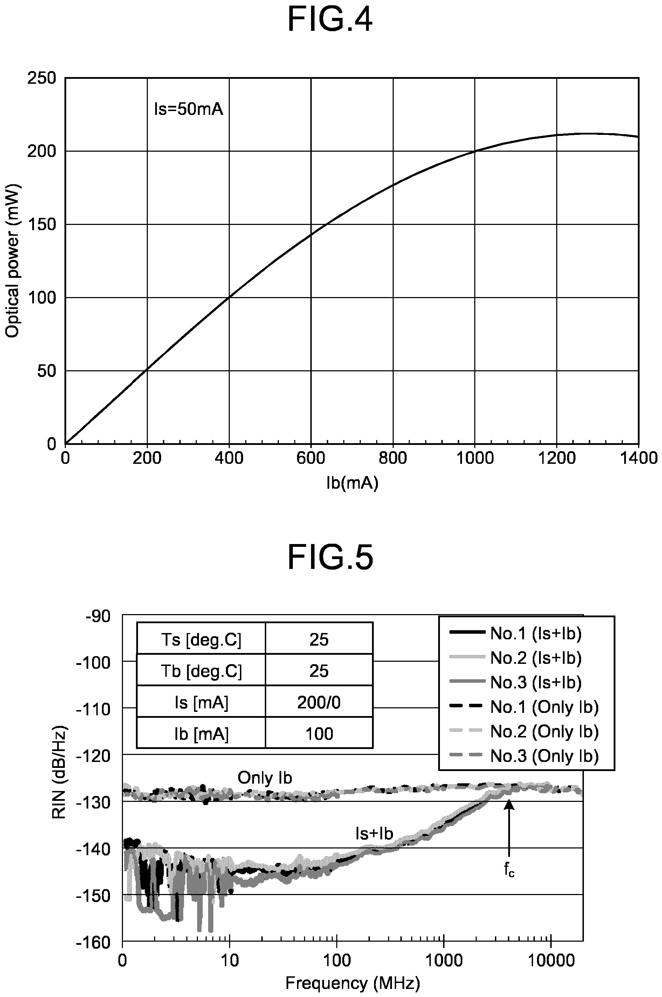

FIG. 4 is a diagram illustrating an example of power (Pf) of the output light (incoherent light) from the booster amplifier with respect to Ib. In FIG. 4, Is is set to 50 mA. In FIG. 4, when Ib is 1000 mA, Pf is about 200 mW. FIGS. 3 and 4 illustrate examples of a light source module produced using semiconductor optical amplifiers having substantially similar characteristics as the seed light source and the booster amplifier, respectively.

Here, the present inventors have found that a state in which the RIN and ripple are simultaneously suppressed can be implemented in the light source module 10 as illustrated in FIG. 1. In the following, first, the suppression of the RIN will be described, next, the suppression of the ripple will be described, and further, a relationship between the suppression of the RIN and the suppression of the ripple will be described.

<Suppression of RIN>

FIG. 5 is a diagram illustrating an example of an RIN spectrum of output light. Specifically, FIG. 5 illustrates a result of measuring RIN of output light from each of light source modules of Nos. 1 to 3 manufactured as the light source module 10. The light source modules of Nos. 1 to 3 are manufactured using semiconductor optical amplifiers having substantially similar characteristics as the seed light source and the booster amplifier, respectively, and have output characteristics equivalent to the characteristics illustrated in FIGS. 3 and 4. For the light source modules of Nos. 1 to 3, it was confirmed for facet reflectivity that $(R1 \times R2)^{1/2}$ was in a range between $10^{-3}$ and $10^{-5}$. In FIG. 5, Ts represents a case temperature (25°C) of the seed light source, and Tb represents a case temperature (25°C) of the booster amplifier.

In FIG. 5, "only Ib" indicates a case where a driving current of 100 mA is supplied only to the booster amplifier and no driving current is supplied to the seed light source (that is, the supplied driving current is 0 mA). In this case, since the seed light source to be amplified is not input to the booster amplifier, the booster amplifier operates as a simple ASE light source.

On the other hand, "Is+Ib" indicates a case where a driving current of 100 mA is supplied to the booster amplifier and a driving current of 200 mA is supplied to the seed light source.

As can be seen from FIG. 5, in the case of "only Ib", an RIN spectrum that is relatively flat with respect to frequency was obtained in any of the light source modules of Nos. 1 to 3. The RIN is considered to be derived from ASE-ASE beat noise in the output light (ASE) output from the booster amplifier as the ASE light source.

On the other hand, in the case of "Is+Ib", it can be seen that the RIN is suppressed on a low frequency side from a specific frequency (corner frequency fc) in any of the light source modules of Nos. 1 to 3. In the case of "Is+Ib", since the seed light (ASE light) output from the seed light source is input to the booster amplifier, the number of photons therein is increased, and it is considered that the booster amplifier is operating in a gain saturation state. Here, it should be noted that in FIG. 5, Ib is a relatively small current of 100 mA, and a driving state in which power of the output light output from the booster amplifier is relatively low, but an RIN suppression state is already achieved.

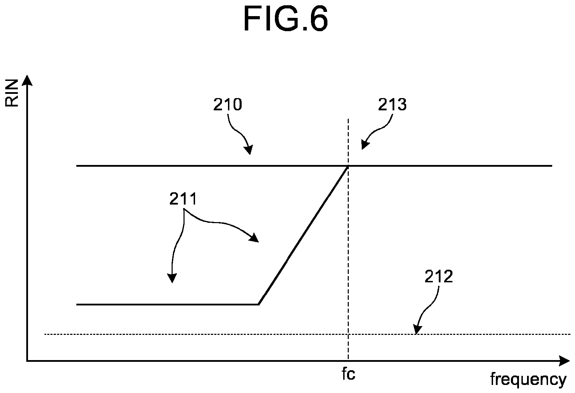

FIG. 6 is a diagram schematically illustrating a spectrum in which the RIN is suppressed.

Here, since the output light output from the light source such as the light source module in the embodiment is the ASE light of the SOA, the RIN thereof should be determined by a magnitude of the ASE-ASE beat noise. In FIG. 6, a level of a line 210 is a level of the ASE-ASE beat noise.

A normal power spectrum width of the ASE light of the SOA is several tens of nm, and is several THz when expressed in frequency. Since a measurement bandwidth of the RIN is as small as several tens of GHz, the RIN is calculated by the following equation (fiber optic test and measurement/edited by Dennis Derickson, Upper Saddle River, 1998).

$$RIN = 0.66/\Delta\nu_{ASE}[Hz^{-1}]$$

Here, 0.66 is a coefficient in a case where the power spectrum of the ASE light is a Gaussian type, and $\Delta\nu_{ASE}$ is the FWHM of the power spectrum.

For example, since the power spectrum of the output light illustrated in FIG. 3 is the Gaussian type and the FWHM thereof is about 30 nm, the RIN is calculated to be about -127 dB/Hz when using Equation (1) above. Such a numerical value substantially matches the result illustrated in FIG. 5.

On the other hand, the RIN of the SOA operating in the gain saturation state is suppressed in a lower frequency region 211 than a corner frequency 213. For example, suppression of the RIN by about 10 dB to 20 dB from the level of the line 210 has been reported (Non Patent Literatures 8, 9, and 10). A line 212 is a level of shot noise.

In the present specification, the suppression of the RIN means that the RIN is suppressed by 10 dB or more as compared with the RIN calculated by the above equation. The degree of suppression of the RIN may be 16 dB or less, or 20 dB or less.

<Suppression of Ripple>

Next, the suppression of the ripple will be described. Specifically, a power spectrum of output light from a light source module (a light source module of No. 4) having output characteristics equivalent to those of the light source module of No. 1 was measured while changing driving conditions of the seed light source and the booster amplifier.

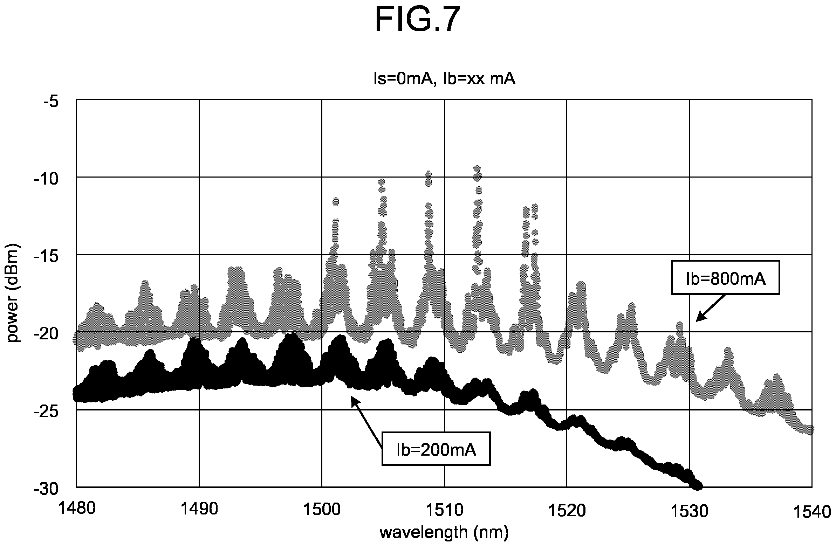

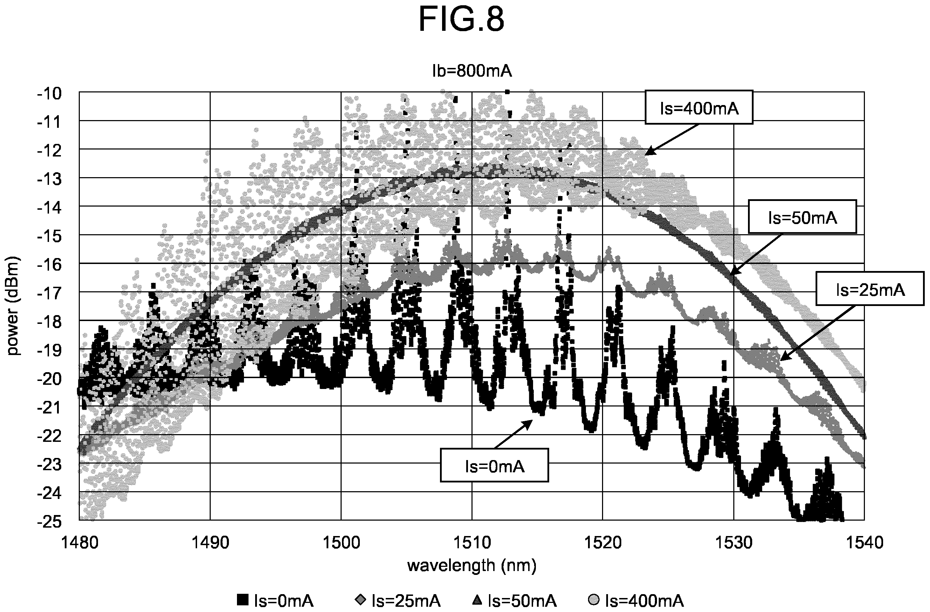

FIG. 7 is a diagram illustrating an example of a power spectrum of the output light when Is is set to 0 mA and Ib is changed. FIG. 8 is a diagram illustrating an example of a power spectrum of the output light when Is is changed.

In FIG. 7, the ripple occurs in both cases where Ib is 200 mA and 800 mA. In particular, when Ib is 200 mA, the ripple occurs although power of the output light is relatively low, about 18 mW. In addition, when Is was set to 0 mA, the ripple was particularly likely to occur. As described above, the ripple is caused by reflection of light at both facets of the SOA. However, the ripple occurs although $(R1 \times R2)^{1/2}$ of the facet reflectivity of the booster amplifier is in a sufficiently small range of between $10^{-3}$ and $10^{-5}$. The fact that the ripple occurs regardless of such a low driving current (low power) and low reflectivity can be said to be an example indicating how difficult it is to suppress the ripple in a pumping light source for Raman amplification in which optical power is several hundred mW in some cases. Note that components of a plurality of different periods were included in the ripple.

On the other hand, as illustrated in FIG. 8, when Is is increased to 25 mA while Ib is fixed to 800 mA, the ripple is suppressed, and when Is is 50 mA, the ripple is further suppressed. However, when Is is further increased to 400 mA, the ripple increases again.

As illustrated in FIG. 8, when the seed light is input to the booster amplifier, the gain saturation state is reached, which results in a region where the ripple is suppressed. This indicates that the ripple can be suppressed by controlling the power of the seed light input to the booster amplifier without reducing the facet reflectivity of the booster amplifier to such an extent that the ripple is suppressed. Since the spectrum of the ASE light of the SOA is as wide as several nm to several tens of nm, it is not easy to perform processing of reducing the facet reflectivity (for example, non-reflection processing) so as to cover such a wide band. Therefore, a technology of suppressing the ripple by controlling the power of the seed light is a technology capable of easing conditions for setting the facet reflectivity of the booster amplifier and difficulty in manufacturing, and is an extremely effective technology in practical use.

The suppression of the ripple is more desirable the smaller the ripple is. A magnitude of the ripple is indicated by the maximum value of a width (peak-to-bottom) of the ripple appearing on the power spectrum at a predetermined wavelength (for example, around 1510 nm). In this case, the ripple is preferably suppressed such that the peak-to-bottom width of the ripple is, for example, 5 dB or less, 3 dB or less, 1 dB or less, or 0.5 dB or less.

Therefore, in a driving method for the light source module as the light source, it is preferable to drive the seed light source and the booster amplifier with the driving currents (Is and Ib) at which the RIN and the ripple are simultaneously suppressed in the incoherent light.

<Configuration of Raman Amplifier>

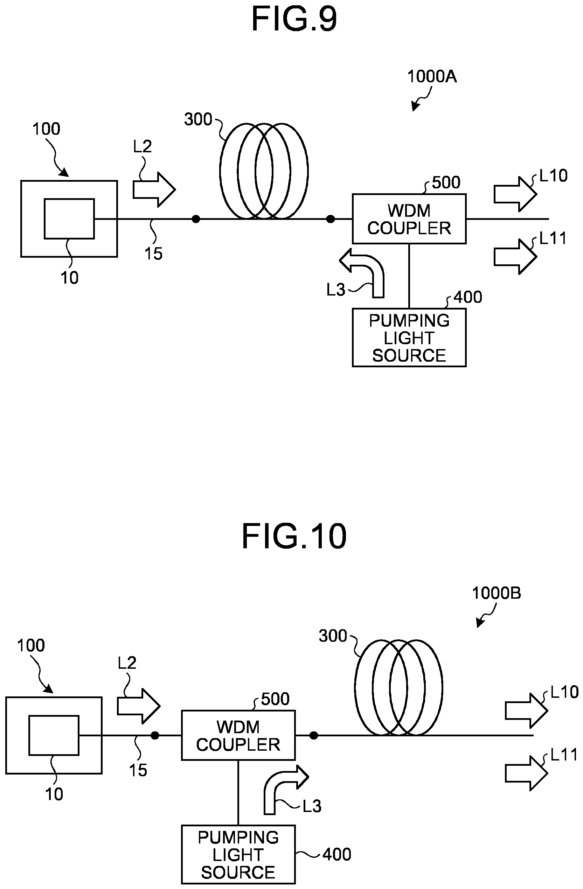

FIG. 9 is a schematic diagram of a Raman amplifier according to a first embodiment. A Raman amplifier 1000A is a so-called backward pumping type, and includes a Raman amplification optical fiber 300, a pumping light source 400, and a wavelength division multiplexing (WDM) coupler 500.

The light source device 100 outputs the incoherent light L2 in which the RIN is suppressed from the output optical fiber 15 to the Raman amplification optical fiber 300. The pumping light source 400 outputs pumping light L3 to the WDM coupler 500 in order to supply the pumping light L3 for Raman amplification to the Raman amplification optical fiber 300. The pumping light L3 has a wavelength shorter by about 100 nm than a wavelength of the incoherent light L2 in order to Raman amplify the incoherent light L2. The pumping light source 400 includes, for example, a Fabry-Perot (FP)-laser diode (LD) type pumped laser with a fiber Bragg grating.

The WDM coupler 500 outputs the pumping light L3 to the Raman amplification optical fiber 300. The Raman amplification optical fiber 300 Raman amplifies the incoherent light L2 while propagating the incoherent light L2. The WDM coupler 500 outputs Raman-amplified light L10 which is light obtained by Raman amplification of the incoherent light L2. In a case where the pumping light L3 is not input and the incoherent light L2 is not Raman amplified, the WDM coupler 500 outputs non-amplified light L11 which is light after the incoherent light L2 is not Raman amplified and has simply propagated through the Raman amplification optical fiber 300.

FIG. 10 is a schematic diagram of a Raman amplifier according to a second embodiment. A Raman amplifier 1000B is a so-called forward pumping type, and includes a Raman amplification optical fiber 300, a pumping light source 400, and a WDM coupler 500 similarly to the Raman amplifier 1000A.

The light source device 100 outputs the incoherent light L2 from the output optical fiber 15 to the WDM coupler 500. The pumping light source 400 outputs pumping light L3 to the WDM coupler 500 in order to supply the pumping light L3 for Raman amplification to the Raman amplification optical fiber 300. The WDM coupler 500 outputs the incoherent light L2 and the pumping light L3 to the Raman amplification optical fiber 300. The Raman amplification optical fiber 300 Raman amplifies the incoherent light L2 while propagating the incoherent light L2, and outputs Raman-amplified light L10. In a case where the pumping light L3 is not input and the incoherent light L2 is not Raman amplified, the Raman amplification optical fiber 300 simply outputs non-amplified light L11 which is light after the incoherent light L2 is not Raman amplified and has simply propagated through the Raman amplification optical fiber 300.

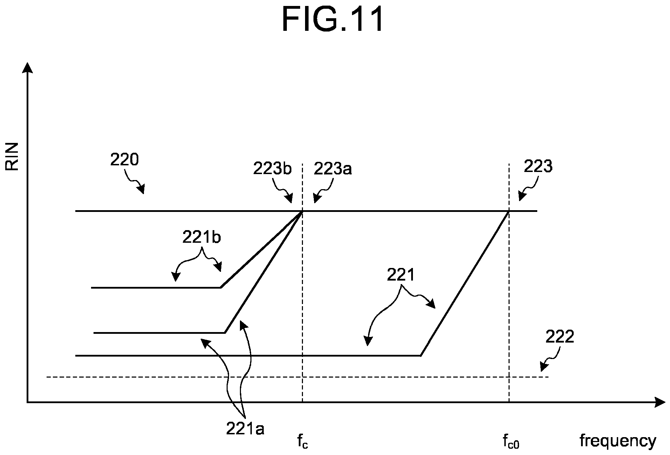

FIG. 11 is a diagram schematically illustrating RIN spectra of the incoherent light L2, the non-amplified light L11, and the Raman-amplified light L10 in the Raman amplifiers 1000A and 1000B as in the first and second embodiments.

In FIG. 11, a level of a line 220 is the level of the ASE-ASE beat noise. A line 222 is the level of the shot noise.

A corner frequency 223 is a corner frequency of the incoherent light L2 before propagating through the Raman amplification optical fiber 300, and is indicated as fc0 in FIG. 11. The RIN of the incoherent light L2 is suppressed in a lower frequency region 221 than the corner frequency 223.

According to intensive studies by the present inventors, a corner frequency of the non-amplified light L11, which is light after the incoherent light L2 has propagated through the Raman amplification optical fiber 300, is shifted to a low frequency side like a corner frequency 223a. The corner frequency fc is expressed by the following Equation (1).

$$fc = 1/(D \cdot \Delta\lambda \cdot L) \tag{1}$$

$\Delta\lambda$ [nm] is a full width at half maximum of a wavelength spectrum of the incoherent light L2, L [km] is a length of the Raman amplification optical fiber 300, and D [ps/nm/km] is an absolute value of chromatic dispersion of the Raman amplification optical fiber 300 at the center wavelength of the incoherent light L2.

Therefore, the RIN of the non-amplified light L11 is suppressed in a lower frequency region 221a than the corner frequency 223a, but the RIN suppression band is narrowed.

Furthermore, according to intensive studies by the present inventors, a corner frequency of the Raman-amplified light L10, which is light after the incoherent light L2 has propagated through the Raman amplification optical fiber 300 and is Raman amplified, is expressed by Equation (1) similarly to the non-amplified light L11, like the corner frequency 223b. Therefore, the RIN of the non-amplified light L11 is suppressed in a lower frequency region 221b than the corner frequency 223b, but the RIN suppression band is not narrowed by Raman amplification. In addition, although the degree of suppression of the RIN is reduced by Raman amplification, the RIN is still lower than the level of the ASE-ASE beat noise of the line 220.

The actually measured corner frequency fc does not necessarily match the value obtained from Equation (1) due to an error or the like, but still substantially match the value obtained from Equation (1), so that it can be said that a frequency at which the suppression of the RIN starts can be estimated by Equation (1). The error tends to be large in a case where the length of the Raman amplification optical fiber 300 is small, in a case where the absolute value of the chromatic dispersion of the Raman amplification optical fiber 300 is small, or in a case where a chromatic dispersion characteristic of the Raman amplification optical fiber 300 varies in a longitudinal direction, and thus, it is necessary to pay attention when performing measurement or applying a measured value. In addition, in a case where the full width at half maximum of the wavelength spectrum of the incoherent light L2 is large, a dispersion slope of the Raman amplification optical fiber 300 becomes a cause of occurrence of the error, and thus it is necessary to pay attention.

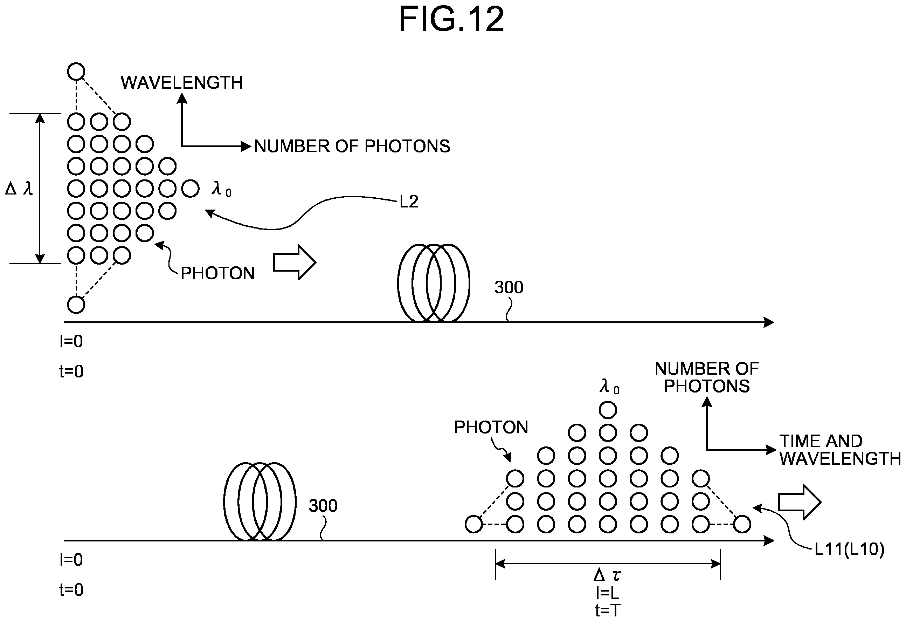

FIG. 12 is a diagram for describing that the RIN suppression band is narrowed after the propagation through the Raman amplification optical fiber 300. In a case where the center wavelength is $\lambda 0$, the FWHM is $\Delta\lambda$, and the incoherent light L2 including a large number of photons having different wavelengths propagates through the Raman amplification optical fiber 300 having a length L [km], when the absolute value of the chromatic dispersion of the Raman amplification optical fiber 300 is D [ps/nm/km], a propagation time of each photon of the non-amplified light L11 (or the Raman-amplified light L10) after propagation has a time spread of $\Delta\tau = D \cdot \Delta\lambda \cdot L$. Therefore, if an observation time is longer than $\Delta\tau$, a temporal fluctuation due to propagation cannot be seen, but if the observation time is shorter than $\Delta\tau$, a fluctuation is observed. Therefore, if the corner frequency fc is defined by $1/\Delta\tau$ = fc, f_c can be used as an index indicating a boundary of the RIN suppression band.

<Corner Frequency Measurement Result: Non-Amplified Light >

Next, a corner frequency measurement result in various combinations of incoherent light and Raman amplification optical fibers will be described. Table 2 shows a combination of the ASE light of the SOA, which is the incoherent light, and the Raman amplification optical fiber, and a value of the corner frequency fc calculated from L, D, and $\Delta\lambda$. However, in measurement examples in Table 2, the RIN spectrum of the non-amplified light was measured without Raman amplification despite the backward pumping as in the first embodiment.

In Table 2, an HNLF refers to a high nonlinearity fiber. The number of light sources is the number of light source modules. In a case where the number of light sources is two, the ASE light of the SOA from each of the two light source modules is subjected to polarization combining. The chromatic dispersion D is an absolute value.

Table 2

| Measurement example | Fiber type | Fiber length L (km) | Chromatic dispersion D(ps/nm/km) | Number of light sources | FWHM $\Delta\lambda$ (nm) | Center wavelength $\lambda$ (nm) | Corner frequency $f_c$ (MHz) |
|---|---|---|---|---|---|---|---|
| 500 | SMF | 50 | 19 | 1 | 28 | 1440 | 38 |
| 501 | SMF | 5 | 19 | 1 | 28 | 1440 | 378 |
| 510 | NZDSF | 50 | 1 | 2 (note) | 28 | 1425 1425 | 714 |
| 510-2 | NZDSF | 50 | 1@1425 nm 2@1488 nm | 2 (note) | 28 | 1425 1488 | 178 |
| 521-2 | HNLF | 2.5 | 39 | 2 (note) | 28 | 1470 1510 | 183 |
| | | | | | | | Note: polarization combining |

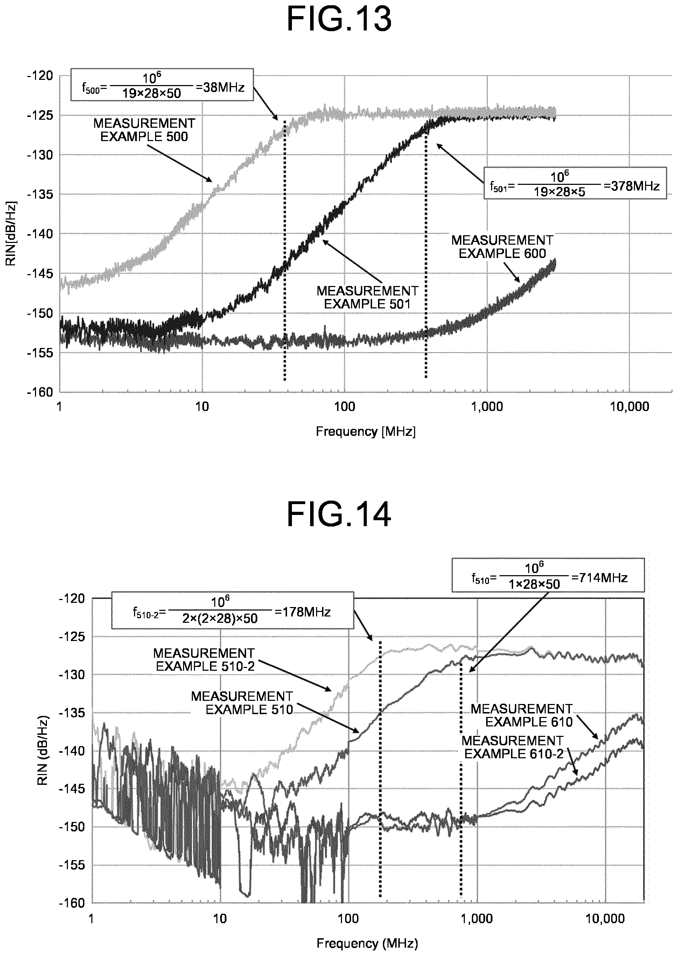

FIG. 13 is a diagram illustrating RIN spectra of measurement examples 500, 501, and 600. The measurement example 600 is an RIN spectrum of the ASE light (corresponding to the incoherent light L2 in FIG. 1) before propagating through the Raman amplification optical fiber (SMF). In FIG. 13, the calculated values in Table 2 are indicated by dotted lines, in which the corner frequency of the RIN spectrum of the incoherent light (non-amplified light) after propagating through the Raman amplification optical fiber is $f_{500}$ in the measurement example 500 and is $f_{501}$ in the measurement example 501, and the corner frequencies substantially matches the corner frequency obtained by the measurement.

Next, in a case where the ASE lights having different wavelengths propagate through the same Raman amplification optical fiber, if the spectra of the ASE lights do not overlap each other, full widths at half maximum of the wavelength spectra can be added to be considered as a full width at half maximum of the total wavelength spectrum. In addition, in a case where the Raman amplification optical fiber is configured by connecting Raman amplification optical fibers having different chromatic dispersions, products of the chromatic dispersions and lengths of the individual Raman amplification optical fibers are accumulated. Therefore, for example, in a case where two ASE lights (the full widths at half maximum are $\Delta\lambda 1$ and $\Delta\lambda 2$, respectively) whose spectra do not overlap each other propagate through a Raman amplification optical fiber in which first and second Raman amplification optical fibers having different chromatic dispersions and lengths are connected, the corner frequency is expressed by the following Equation (2). D1 and L1 are the chromatic dispersion and the length of the first Raman amplification optical fiber, respectively, and D2 and L2 are the chromatic dispersion and the length of the second Raman amplification optical fiber, respectively.

$$fc = 1/[(\Delta\lambda1+\Delta\lambda2)\cdot(D1\cdot L1+D2\cdot L2)] \qquad (2)$$

FIG. 14 is a diagram illustrating RIN spectra of measurement examples 510, 510-2, 610, and 610-2. The measurement examples 610 and 610-2 are RIN spectra of ASE light (corresponding to the incoherent light L2 in FIG. 1) before propagation through the Raman amplification optical fiber (NZDSF). In FIG. 14, the calculated values in Table 2 are indicated as $f_{510}$ in the measurement example 510 and as $f_{510-2}$ in the measurement example 510-2, and substantially match the corner frequency obtained by the measurement. In particular, in the measurement example 510-2, the corner frequency calculated by Equation (2) and the measurement result substantially match each other.

Table 3 shows a combination of the ASE light of the SOA and the Raman amplification optical fiber, and the value of the corner frequency fc calculated from L, D, and $\Delta\lambda$. In measurement examples in Table 3, as the Raman amplification optical fiber, a Raman amplification optical fiber in which two types of Raman amplification optical fibers (Fibers 1, 2) having different lengths and chromatic dispersions are connected in this order is used.

Table 3

| Measurement example | Fiber type | Fiber length L (km) | Chromatic dispersion D(ps/nm/km) | Number of light sources | FWHM $\Delta\lambda$ (nm) | Center wavelength $\lambda$ (nm) | Corner frequency $f_c$ (MHz) |
|---|---|---|---|---|---|---|---|
| 530 | Fiber 1: HNLF Fiber 2: NZDSF | Fiber 1: 1.4 Fiber 2: 50 | Fiber 1: 39 Fiber 2: 1 | 2 (note) | 28 | 1425 1425 | 341 |
| Note: polarization combining | | | | | | | |

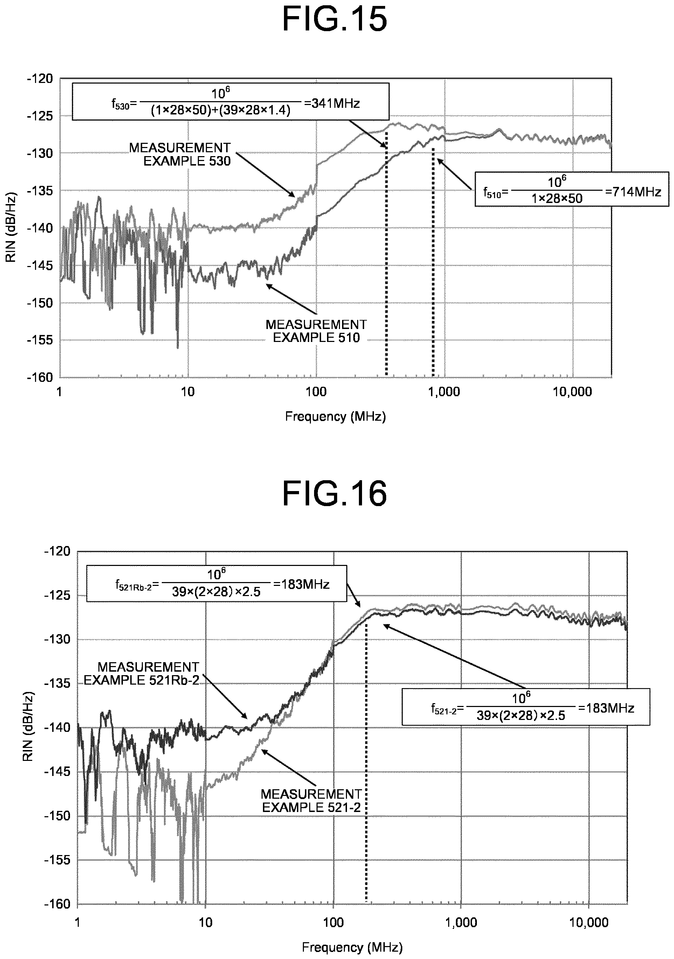

FIG. 15 is a diagram illustrating RIN spectra of measurement examples 510 and 530. The measurement example 510 is the same as that illustrated in FIG. 14. In FIG. 15, the calculated values in Table 2 or 3 are indicated as $f_{510}$ in the measurement example 510 and as $f_{530}$ in the measurement example 530, and substantially match the corner frequency obtained by the measurement. In particular, in the measurement example 530, the corner frequency calculated by Equation (2) and the measurement result substantially match each other.

<Corner Frequency Measurement Result: Raman-Amplified Light>

Next, a result of measuring the corner frequency of the RIN spectrum of the Raman-amplified light will be described. In order to Raman amplify the ASE light while maintaining superiority of the ASE light in which the RIN is suppressed, the main point is whether or not the RIN suppression band of the ASE light is preserved in the Raman amplification process.

FIG. 16 is a diagram illustrating RIN spectra of measurement examples 521-2 and 521Rb-2. The measurement example 521-2 is an RIN spectrum of the non-amplified light in the Raman amplification fiber shown in Table 2, and the measurement example 521Rb-2 is an RIN spectrum in a case where Raman amplification is performed with the configuration of the backward pumping of the second embodiment. In FIG. 16, the calculated values in Table 2 are indicated as $f_{521-2}$ in the measurement example 521-2 and as $f_{521Rb-2}$ in the measurement example 521Rb-2, and substantially match the corner frequency obtained by the measurement. As illustrated in FIG. 16, it has been found that, when the ASE light in which the RIN is suppressed is Raman amplified, the RIN of the Raman-amplified light increases, but the corner frequency is as in Equation (1) and the RIN suppression band is maintained.

Table 4 shows a combination of the ASE light of the SOA and the Raman amplification optical fiber, and the value of the corner frequency fc calculated from L, D, and $\Delta\lambda$. In a measurement example 520Rf and a measurement example 520Rb, the ASE light and the Raman amplification optical fiber are the same, but in the measurement example 520Rf, Raman amplification was performed with the configuration of the forward pumping as in the second embodiment, and in the measurement example 520Rb, Raman amplification was performed with the configuration of the backward pumping as in the first embodiment.

Table 4

| Measurement example | Fiber type | Fiber length L (km) | Chromatic dispersion D(ps/nm/km) | Number of light sources | FWHM Δλ (nm) | Center wavelength λ (nm) | Corner frequency $f_c$ (MHz) |
|---|---|---|---|---|---|---|---|
| 520Rf | HNLF | 1.4 | 39 | 2 (note) | 28 | 1425 1425 | 654 |
| 520Rb | HNLF | 1.4 | 39 | 2 (note) | 28 | 1425 1425 | 654 |
| | | | | | | | Note: polarization combining |

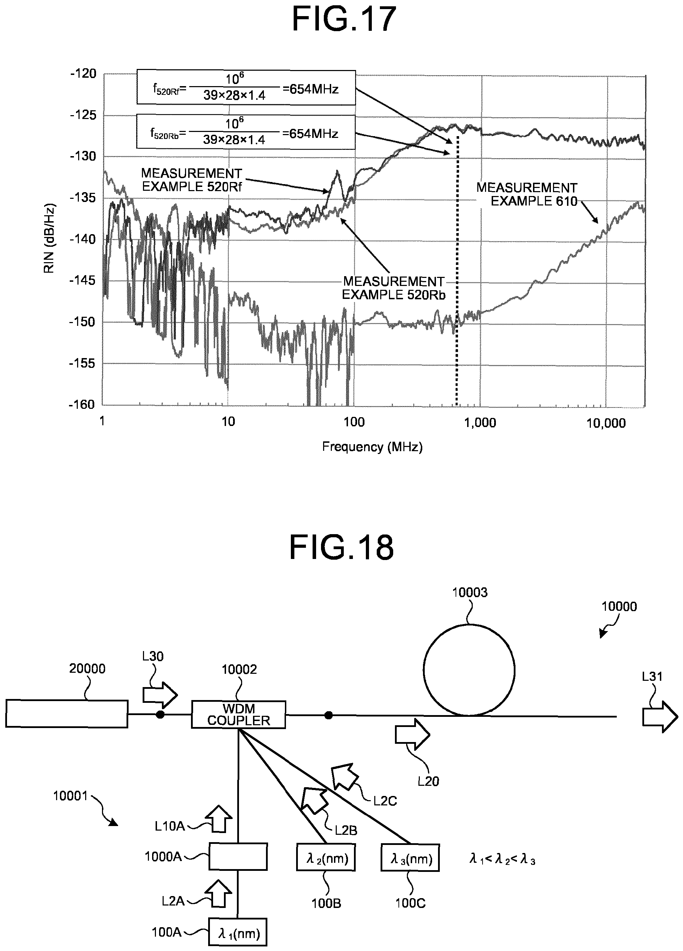

FIG. 17 is a diagram illustrating RIN spectra of the measurement examples 520Rf and 520Rb and the measurement example 610. The measurement example 610 is an RIN spectrum of ASE light (corresponding to the incoherent light L2 in FIG. 1) before propagating through the Raman amplification optical fiber (HNLF). As can be seen from FIG. 17, no difference in corner frequency depending on an excitation direction can be found. However, it can be seen that RIN characteristics of the backward pumping are slightly stable.

As described above, the corner frequency fc [Hz] at which the suppression of the RIN starts in the Raman-amplified incoherent light is calculated by the following Equation (1):

$$Fc = 1/(D \cdot \Delta\lambda \cdot L) \tag{1}$$

in which the full width at half maximum of the wavelength spectrum of the incoherent light is Δλ [nm], the length of the Raman amplification optical fiber is L [km], and the absolute value of the chromatic dispersion of the Raman amplification optical fiber at the center wavelength of the incoherent light is D [ps/nm/km], so that the RIN suppression band of the Raman-amplified incoherent light can be estimated and controlled, and the Raman-amplified incoherent light can be obtained while maintaining the superiority of the suppression of the RIN.

As disclosed in Non Patent Literatures 4 and 5, considering that the RIN transfer is about 100 MHz, it is preferable to combine Δλ, L, and D such that fc is 100 MHz or more. Furthermore, it is preferable that Δλ, L, and D are combined such that fc is 500 MHz or more, 1 GHz or more, or 10 GHz or more.

<Raman Amplification System>

FIG. 18 is a schematic diagram of a Raman amplification system including the Raman amplifier according to the first embodiment. A Raman amplification system 10000 includes a pumping light source 10001, a WDM coupler 10002, and a transmission optical fiber 10003.

The pumping light source 10001 includes a light source device 100A that outputs ASE light L2A of an SOA whose center wavelength is $\lambda_1$, a light source device 100B that outputs ASE light L2B of an SOA whose center wavelength is $\lambda_2$, a light source device 100C that outputs ASE light L2C of an SOA whose center wavelength is $\lambda_3$, and the Raman amplifier 1000A that performs Raman amplification on the ASE light L2A and outputs the Raman-amplified ASE light as Raman-amplified light L10A. Here, $\lambda_1 < \lambda_2 < \lambda_3$. $\lambda_1$, $\lambda_2$, and $\lambda_3$ are, for example, 1425 nm, 1455 nm, and 1495 nm as shown in Table 1.

Each of the light source devices 100A, 100B, and 100C has the same configuration as the light source device 100 illustrated in FIG. 1. The Raman amplifier 1000A has a configuration illustrated in FIG. 9.

A light source device 20000 outputs wavelength-multiplexed signal light L30 of a C+L band to the WDM coupler 10002. The WDM coupler 10002 outputs, to the transmission optical fiber 10003, the wavelength-multiplexed signal light L30 and wavelength-multiplexed pumping light L20 which is light obtained by wavelength multiplexing the Raman-amplified light L10A, the ASE light L2B, and the ASE light L2C.

The transmission optical fiber 10003 is, for example, an SMF having a length of 40 km. The transmission optical fiber 10003 Raman amplifies the wavelength-multiplexed signal light L30 by receiving the wavelength-multiplexed pumping light L20 to obtain the amplified wavelength-multiplexed signal light L31.

As described with reference to FIG. 19, in order to implement high gain flatness over the entire C+L band, it is necessary to amplify ASE light on a short wavelength side by some means or method. In the Raman amplification system 10000 of FIG. 18, since the ASE light L2A on the short wavelength side is amplified using the Raman amplifier 1000A, it is possible to implement high gain flatness over the entire C+L band as illustrated in FIG. 19(a), for example.

In the above embodiments, the seed light in the light source module is the ASE light, but the seed light may be incoherent light such as spontaneous emission (SE) light.

In the above embodiments, the seed light source is a semiconductor optical amplifier, but the seed light source may include at least one of a super luminescent diode (SLD), an SOA, and an ASE light source including a rare earth doped optical fiber. Such an SLD, SOA, and ASE light source are suitable as incoherent light sources.

Further, the present invention is not limited by the above embodiments. The present invention also includes a configuration in which the above-described components are appropriately combined. In addition, further effects and modifications can be easily derived by those skilled in the art. Therefore, a wider aspect of the present invention is not limited to the above embodiments, and various modifications are possible.

Reference Signs List

10 LIGHT SOURCE MODULE
11 SEED LIGHT SOURCE
12, 14 OPTICAL ISOLATOR
13 BOOSTER AMPLIFIER
13a FIRST FACET
13b SECOND FACET
15 OUTPUT OPTICAL FIBER
100, 100A, 100B, 100C LIGHT SOURCE DEVICE
101, 102 DRIVING DEVICE
210, 212, 220, 222 LINE
211, 221, 221a, 221b LOWER FREQUENCY REGION
213, 223, 223a, 223b CORNER FREQUENCY
300 RAMAN AMPLIFICATION OPTICAL FIBER
400 PUMPING LIGHT SOURCE
500 WDM COUPLER
1000A, 1000B RAMAN AMPLIFIER
10000 RAMAN AMPLIFICATION SYSTEM
10001 PUMPING LIGHT SOURCE
10002 WDM COUPLER
10003 TRANSMISSION OPTICAL FIBER
20000 LIGHT SOURCE DEVICE
C1, C2 DRIVING CURRENT
L1 SEED LIGHT
L2 INCOHERENT LIGHT
L2A, L2B, L2C ASE LIGHT
L3 PUMPING LIGHT
L10, L10A RAMAN-AMPLIFIED LIGHT
L11 NON-AMPLIFIED LIGHT
L20 WAVELENGTH-MULTIPLEXED PUMPING LIGHT
L30 WAVELENGTH-MULTIPLEXED SIGNAL LIGHT
L31 AMPLIFIED WAVELENGTH-MULTIPLEXED SIGNAL LIGHT

**Claims**

1. A Raman amplifier comprising:

a Raman amplification optical fiber configured to Raman amplify incoherent light in which relative intensity noise (RIN) is suppressed while transmitting the incoherent light; and
a pumping light source configured to supply pumping light to the Raman amplification optical fiber,
wherein a corner frequency fc [Hz] at which the suppression of the RIN starts in the Raman-amplified incoherent light is estimated by using the following Equation (1):

$$\mathrm{fc} = 1 / (\mathrm{D} \cdot \Delta\lambda \cdot \mathrm{L}) \qquad\qquad (1)$$

in which a full width at half maximum of a wavelength spectrum of the incoherent light is $\Delta\lambda$ [nm], a length of the Raman amplification optical fiber is L [km], and an absolute value of chromatic dispersion of the Raman amplification optical fiber at a center wavelength of the incoherent light is D [ps/nm/km].

2. The Raman amplifier according to claim 1, wherein the Raman amplifier is configured to have a combination of $\Delta\lambda$, L, and D to be fc of 10 GHz or more.

3. The Raman amplifier according to claim 1, wherein the Raman amplifier is configured to have a combination of $\Delta\lambda$, L, and D to be fc of 1 GHz or more.

4. The Raman amplifier according to claim 1, wherein the Raman amplifier is configured to have a combination of $\Delta\lambda$, L, and D to be fc of 500 MHz or more.

5. The Raman amplifier according to claim 1, wherein the Raman amplifier is configured to have a combination of $\Delta\lambda$, L, and D to be fc of 100 MHz or more.

6. The Raman amplifier according to any one of claims 1 to 5, wherein the incoherent light is output from an incoherent light source including semiconductor optical amplifiers connected in multiple stages.

7. The Raman amplifier according to claim 6, wherein the incoherent light source is driven such that the relative intensity noise (RIN) and ripple are simultaneously suppressed in the incoherent light.

8. A method for designing a Raman amplifier including a Raman amplification optical fiber configured to Raman amplify incoherent light in which relative intensity noise (RIN) is suppressed while transmitting the incoherent light, and a pumping light source configured to supply pumping light to the Raman amplification optical fiber, the method comprising:

estimating a corner frequency fc [Hz] at which the suppression of the RIN starts in the Raman-amplified incoherent light by using the following Equation (1):

$$fc=1/(D \cdot \Delta\lambda \cdot L) \qquad\qquad (1)$$

in which a full width at half maximum of a wavelength spectrum of the incoherent light is $\Delta\lambda$ [nm], a length of the Raman amplification optical fiber is L [km], and a chromatic dispersion of the Raman amplification optical fiber at a center wavelength of the incoherent light is D [ps/nm/km].

EP 4 502 722 A1

# FIG.1

# FIG.2

# FIG.3

FWHM1460-1432=28nm

# FIG.4

# FIG.5

# FIG.6

# FIG.7

Is=0mA, Ib=xx mA

EP 4 502 722 A1

# FIG.8

EP 4 502 722 A1

# FIG.9

# FIG.10

# FIG.11

# FIG.12

EP 4 502 722 A1

# FIG.13

$$f_{500}=\frac{10^6}{19\times28\times50}=38\text{MHz}$$

MEASUREMENT
EXAMPLE 500

$$f_{501}=\frac{10^6}{19\times28\times5}=378\text{MHz}$$

MEASUREMENT
EXAMPLE 600

MEASUREMENT
EXAMPLE 501

RIN[dB/Hz]

Frequency [MHz]

# FIG.14

$$f_{510}=\frac{10^6}{1\times28\times50}=714\text{MHz}$$

$$f_{510\text{-}2}=\frac{10^6}{2\times(2\times28)\times50}=178\text{MHz}$$

MEASUREMENT
EXAMPLE 510-2

MEASUREMENT
EXAMPLE 510

MEASUREMENT
EXAMPLE 610

MEASUREMENT
EXAMPLE 610-2

RIN (dB/Hz)

Frequency (MHz)

# FIG.15

$$f_{530}=\frac{10^6}{(1\times28\times50)+(39\times28\times1.4)}=341\text{MHz}$$

MEASUREMENT
EXAMPLE 530

$$f_{510}=\frac{10^6}{1\times28\times50}=714\text{MHz}$$

MEASUREMENT
EXAMPLE 510

RIN (dB/Hz)

Frequency (MHz)

# FIG.16

$$f_{521Rb-2}=\frac{10^6}{39\times(2\times28)\times2.5}=183\text{MHz}$$

MEASUREMENT
EXAMPLE 521Rb-2

$$f_{521-2}=\frac{10^6}{39\times(2\times28)\times2.5}=183\text{MHz}$$

MEASUREMENT
EXAMPLE 521-2

RIN (dB/Hz)

Frequency (MHz)

# FIG.17

$$f_{520Rf}=\frac{10^6}{39\times28\times1.4}=654\text{MHz}$$

$$f_{520Rb}=\frac{10^6}{39\times28\times1.4}=654\text{MHz}$$

MEASUREMENT EXAMPLE 520Rf

MEASUREMENT EXAMPLE 610

MEASUREMENT EXAMPLE 520Rb

RIN (dB/Hz)

Frequency (MHz)

# FIG.18

$\lambda_1<\lambda_2<\lambda_3$

# FIG.19

(a)

(b)

(c)

## INTERNATIONAL SEARCH REPORT

| | International application No. |
|---|---|
| | **PCT/JP2023/013208** |

**A. CLASSIFICATION OF SUBJECT MATTER**

*G02F 1/35*(2006.01)i
FI: G02F1/35 501

According to International Patent Classification (IPC) or to both national classification and IPC

**B. FIELDS SEARCHED**

Minimum documentation searched (classification system followed by classification symbols)

G02F1/00-1/125; G02F1/21-7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | WO 2022/054860 A1 (THE FURUKAWA ELECTRIC CO., LTD.) 17 March 2022 (2022-03-17) <br> paragraphs [0034]-[0087], fig. 1-18 | 1-7 |
| A | | 8 |
| A | US 2003/0053192 A1 (ISLAM, M. N. et al.) 20 March 2003 (2003-03-20) <br> entire text, all drawings | 1-8 |
| A | FLUDGER, C. R. S. et al., Pump to Signal RIN Transfer in Raman Fiber Amplifiers, JOURNAL OF LIGHTWAVE TECHNOLOGY, August 2003, vol. 19, no. 8, pp. 1140-1148 <br> entire text, all drawings | 1-8 |
| A | MORIMOTO, M. et al., Co-Propagating Dual-Order Distributed Raman Amplifier Utilizing Incoherent Pumping, IEEE PHOTONICS TECHNOLOGY LETTERS, 09 March 2017, vol. 29, no. 7, pp. 567-570 <br> entire text, all drawings | 1-8 |

☐ Further documents are listed in the continuation of Box C.    ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **25 May 2023** | **06 June 2023** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**
Information on patent family members

International application No.

**PCT/JP2023/013208**

| Patent document cited in search report | | | Publication date (day/month/year) | Patent family member(s) | | | Publication date (day/month/year) |
|---|---|---|---|---|---|---|---|
| WO | 2022/054860 | A1 | 17 March 2022 | CN | 116057465 | A | |
| US | 2003/0053192 | A1 | 20 March 2003 | US | 2003/0035202 | A1 | |
| | | | | US | 2003/0053507 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016212370 A

- US 7215836 B

**Non-patent literature cited in the description**

- Broadband flat-noise Raman amplifier using low-noise bidirectionally pumping sources. **KADO, SOKO et al.** Proceedings 27th European Conference on Optical Communication (Cat. No. 01TH8551). IEEE, 2001, 38-39
- **EMORI, YOSHIHIRO** ; **KADO, SOKO** ; **NAMIKI, SHU.** Independent control of the gain and noise figure spectra of Raman amplifiers using bidirectional pumping.. *Furukawa Review*, 2003, vol. 23, 11-15
- **PELOUCH** ; **WAYNE S**. Raman amplification: An enabling technology for long-haul coherent transmission systems.. *Journal of Lightwave Technology*, 2015, vol. 34 (1), 6-19
- **KEITA, KAFING et al.** Relative intensity noise transfer of large-bandwidth pump lasers in Raman fiber amplifiers.. *JOSA B*, 2006, vol. 23 (12), 2479-2485
- **FLUDGER, C. R. S.** ; **HANDEREK, V.** ; **MEARS, R. J.** Pump to signal RIN transfer in Raman fiber amplifiers.. *Journal of Lightwave Technology*, 2001, vol. 19 (8), 1140
- Broadband Raman amplifiers design and practice. **NAMIKI, SHU** ; **EMORI, YOSHIHIRO**. Optical Amplifiers and Their Applications. Optical Society of America, 2000, OMB2

- **SAAVEDRA, GABRIEL et al.** Inter-channel stimulated Raman scattering and its impact in wideband transmission systems. *2018 Optical Fiber Communications Conference and Exposition (OFC)*, 2018, Th1C.3
- Noise suppression and intensity modulation using gain-saturated semiconductor optical amplifier.. **YAMATOYA, T.** ; **KOYAMA, F.** ; **IGA, K.** Optical Amplifiers and Their Applications. Optical Society of America, 2000, OMD12
- High power superluminescent diodes for multi-wavelength light sources. **KOYAMA, F.** Conference Proceedings. LEOS'97. 10th Annual Meeting IEEE Lasers and Electro-Optics Society 1997 Annual Meeting. IEEE, 1997, 333-334
- **ZHAO, MINGSHAN** ; **MORTHIER, GEERT** ; **BAETS, ROEL.** Analysis and optimization of intensity noise reduction in spectrum-sliced WDM systems using a saturated semiconductor optical amplifier.. *IEEE Photonics Technology Letters*, 2002, vol. 14 (3), 390-392
- **MORIMOTO, MASAHITO et al.** Co-propagating dual-order distributed Raman amplifier utilizing incoherent pumping.. *IEEE Photonics Technology Letters*, 2017, vol. 29 (7), 567-570
- Raman amplification using high-power incoherent semiconductor pump sources.. **VAKHSHOORI, D. et al.** Optical Fiber Communication Conference.. Optical Society of America, 2003, PD47